# EUROPÄISCHE PATENTSCHRIFT

(11) **EP 0 911 972 B1**
(45) Veröffentlichungstag und Bekanntmachung des Hinweises auf die Patenterteilung: **03.11.2004**
(21) Anmeldenummer: 98117535.9
(22) Anmeldetag: 16.09.1998
(51) Int. Cl.: H03K 17/94, B41F 33/14, B41F 33/00, B41F 33/12

(54) **Verfahren zum Einschalten einer Maschine**
Method for switching on a machine
Procédé pour la mise en marche d'une machine

(30) Priorität: 21.10.1997 DE 19746323
(43) Veröffentlichungstag der Anmeldung: 28.04.1999
(60) Teilanmeldung: 04102929.9
(73) Patentinhaber: Heidelberger Druckmaschinen Aktiengesellschaft, 69115 Heidelberg (DE)
(72) Erfinder: Weil, Stefan, D-68526 Ladenburg (DE); Pritschow, Michael, 69168 Wiesloch (DE); Gäng, Manfred, D-68794 Oberhausen/Rheinhausen (DE)

(56) Entgegenhaltungen:
- EP-A- 0 095 664
- EP-A- 0 649 744
- US-A- 4 482 845
- US-A- 5 410 148

## Beschreibung

Die Erfindung betrifft ein Verfahren zum Einschalten einer Maschine.

Maschinen mit Gefahrenpotential wie Druckmaschinen werden bisher zum Beispiel durch manuelle Betätigung eines elektromechanischen Tasters eingeschaltet. Ein solcher Taster verlangt eine bestimmte Mindest-Betätigungskraft und hat zweckmäßigerweise einen definierten Druckpunkt. Dadurch läßt sich ein unbeabsichtigtes Anfahren der Maschine zuverlässig verhindern, zumal wenn zusätzliche Sicherheitseinrichtungen wie akustische Anfahrwarnungen und Not-Aus-Taster vorgesehen sind. Ferner ist aus der EP 0 095 664 B2 eine Steuervorrichtung für eine Druckmaschine bekannt, bei der eine Befehlstaste zweimal gedrückt werden muß, damit der Befehl ausgeführt wird, um Fehlermöglichkeiten zu verringern.

Zur Vereinfachung der Bedienung wäre es wünschenswert, wenn das Einschalten der Maschine auch mit anderen Bedienelementen als elektromechanischen Schaltern oder Tastern erfolgen könnte. Solche Bedienelemente sind zum Beispiel berührungssensitive Bildschirme, sogenannte Touch-Screens, berührungssensitive Sensorfelder, sogenannte Touch-Pads, und Folientastaturen, wie sie bei Datenendgeräten, sogenannten Terminals, oder Personalcomputern verwendet werden. Ein Terminal oder Personalcomputer mit solchen Bedienelementen kann zwar zur Steuerung und/oder Überwachung vieler Funktionen einer Druckmaschine verwendet werden, gestattet aber aus Sicherheitsgründen bisher nicht das Anfahren der Druckmaschine, da die Bedienelemente leicht versehentlich auslösbar sind, beispielsweise durch versehentliches Berühren mit dem Finger oder durch Wischbewegungen, wie sie beim Reinigen eines Touch-Screens auftreten.

*Aus der US 4,482,845 ist ein Verfahren bekannt, womit das versehentliche Auslösen eines Schalters, Tasters oder ähnlichem verhindert wird Dieses Verfahren schließt mit einer zeitlichen Abfolge, innerhalb der das Drücken oder Berühren eines Schalters, Tasters oder ähnliche erfolgen muss, eine Fehlbedienung aus. Nachteilig an diesem Verfahren ist, dass die zeitliche Abfolge von der negativen Flanke des Auslöseimpulses, d. h. vom Zeitpunkt des Loslassens des Schalters, Tasters oder ähnliche abhängt. Zur Verhinderung des versehentlichen Einschaltens einer Maschine, insbesondere Druckmaschine ist ein derartiges Verfahren nicht geeignet.*

Der Erfindung liegt die Aufgabe zugrunde, berührungs- oder näherungssensitive Bedienelemente mit einem zuverlässigen Schutz vor Fehlauslösung zu versehen, um diese für Einschaltvorgänge bei Maschinen mit Gefahrenpotential verwenden zu können.

*Die Aufgabe wird gemäß der kennzeichnenden Merkmale von Anspruch 1 gelöst, vorteilhafte Ausgestaltungen ergeben sich aus den abhängigen Ansprüchen 2-7.*

In einer bevorzugten Ausführungsform sind der Sensor oder das Sensorfeld bzw. die Bedienfläche berührungssensitiv, wobei alternativ aber auch Näherungsschalter verwendet werden können, die bereits ansprechen, wenn sich ihnen ein Körperteil des Maschinenbedieners nähert. Die Erfindung eignet sich besonders für Touch-Screens und Touch-Pads als Bedienfläche, aber auch für Tastaturen, speziell Folientastaturen.

Ein günstiger Kompromiß zwischen Sicherheit und Bedienungskomfort insbesondere bei Druckmaschinen besteht bei dem Verfahren darin, die Zeitbedingungen so zu wählen, daß der vorbestimmte zeitliche Abstand zwischen dem Zeitpunkt des ersten Erscheinens des Einschaltsignals und dem ersten vorbestimmten Zeitintervall 1 Sekunde beträgt und daß das erste vorbestimmte Zeitintervall 2 Sekunden beträgt. Außerdem sollte das zweite vorbestimmte Zeitintervall wenigstens 3 und höchstens 6 Sekunden betragen und dem ersten vorbestimmten Zeitintervall unmittelbar folgen, wobei es dem ersten vorbestimmten Zeitintervall aber auch in irgendeinem vorbestimmten zeitlichen Abstand folgen kann.

Die Erfindung ist nicht auf im wesentlichen ebene Bedienflächen wie Touch-Screens oder Touch-Pads beschränkt. Vielmehr bezieht sich der Ausdruck Bedienfläche auf jede Anordnung von Sensoren entlang einer Fläche, die im Raum gekrümmt oder winklig sein kann.

Die Erfindung ist besonders für Einschaltvorgänge bei Druckmaschinen, aber auch bei anderen Maschinen geeignet, beispielsweise Bindemaschinen, Schneidemaschinen und anderen Maschinen im Druckereiumfeld.

Ausführungsbeispiele der Erfindung sind in den Zeichnungen dargestellt und werden im folgenden näher beschrieben. Es zeigen:
- Fig. 1: eine Bedieneinheit in Form eines Personalcomputers oder Terminals mit TouchScreen, die mit einer Druckmaschinensteuerung verbunden ist,
- Fig. 2: ein Flußdiagramm, das den Betrieb der Überwachungseinheit in der Druckmaschinensteuerung in Fig. 1 zeigt,
- Fig. 3a; 3b: Zeitdiagramme zur Erläuterung des Überwachungsbetriebs, und

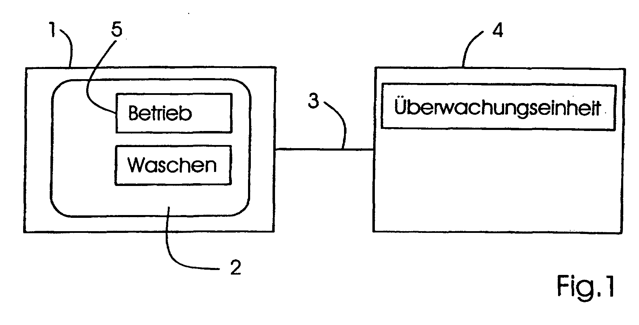

Die in Fig. 1 gezeigte Bedieneinheit 1 befindet sich am Leitstand einer Druckmaschine und umfaßt einen Personalcomputer oder ein Terminal mit einem Touch-Screen 2, der über eine elektrische oder optische Verbindung 3 (z.B. Kabel, HF-Leiter oder Lichtwellenleiter mit geeigneten Schnittstellen zur Datenübertragung) mit einer Druckmaschinensteuerung 4 verbunden ist. Während der Berührung eines Teilfeldes 5 mit der Aufschrift "Betrieb" auf dem Touch-Screen 2 durch den Maschinenbediener sendet die Bedieneinheit 1 ein Einschaltsignal an die Druckmaschinensteuerung 4, die eine Echtzeitsteuerung beliebiger Ausprägung sein kann. Auf dem Touch-Screen 2 können weitere Teilfelder vorgesehen sein, um weitere sicherheitsrelevante Vorgänge wie Waschen, Wendungsumstellung etc. auszulösen. Beispielsweise kann ein Teilfeld mit der Aufschrift "Waschen" vorgesehen sein, mit dem ein Waschbetrieb gestartet wird, wenn bestimmte Bedingungen erfüllt sind. Dies wird nachfolgend für das Beispiel der Inbetriebnahme der Druckmaschine beschrieben.

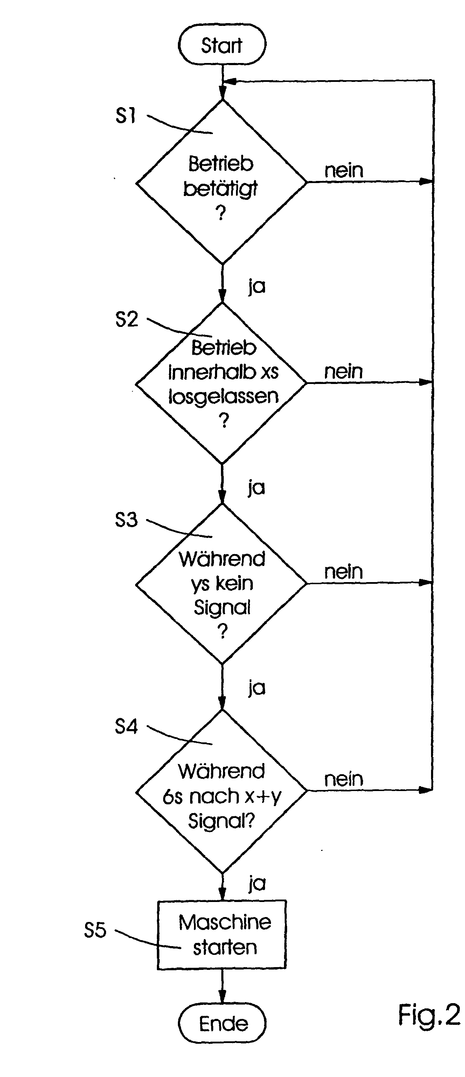

Die Druckmaschinensteuerung 4 enthält eine Überwachungseinheit, welche die Einschaltsequenz überwacht, d.h. die zeitliche Reihenfolge, in der das Einschaltsignal erscheint. Dieser Betrieb ist in Fig. 2 dargestellt, wobei x eine "Einzeit" ist, d.h. die Zeit, während der das Einschaltsignal erstmalig erscheint, y eine "Auszeit" ist, während der kein Einschaltsignal erscheinen sollte, und x+y eine Anfahrwarnungszeit der Druckmaschine ist.

Im Verfahrensschritt S1 wird fortlaufend geprüft, ob das Einschaltsignal vorhanden ist oder nicht. Parallel dazu erfolgt eine laufende Sicherheitsabfrage an Überwachungseinrichtungen an der Druckmaschine, die z.B. überwachen, ob Schutzhauben geschlossen sind etc.. Sobald bei sicherer Druckmaschine das Einschaltsignal erscheint, wird die akustische Anfahrwarnung ausgelöst und geht die Überwachung mit dem Verfahrensschritt S2 weiter, in dem geprüft wird, ob das Einschaltsignal innerhalb von x Sekunden wieder verschwindet. Falls nein, kehrt die Überwachung zum Verfahrensschritt S1 zurück und wartet auf ein neues Einschaltsignal. Falls das Einschaltsignal im Verfahrensschritt S2 innerhalb von x Sekunden nach seinem ersten Erscheinen wieder verschwindet, fährt die Überwachung mit dem Verfahrensschritt S3 fort, in dem geprüft wird, ob während y weiterer Sekunden ein Einschaltsignal erscheint oder nicht. Falls ja, geht die Überwachung zum Verfahrensschritt S1 zurück. Falls innerhalb von y Sekunden kein Einschaltsignal erscheint, wird im Verfahrensschritt S4 geprüft, ob das Einschaltsignal innerhalb einer Zeit von beispielsweise sechs Sekunden nach Ablauf der Anfahrwarnungszeit erneut erscheint. Falls nicht, kehrt die Überwachung zum Verfahrensschritt S1 zurück. Falls die Betriebstaste (d.h. das Teilfeld 5) in dem Zeitintervall von sechs Sekunden ein zweites Mal betätigt worden ist, wird im Verfahrensschritt S5 ein Betrieb der Druckmaschine mit beispielsweise 3000 Druck pro Stunde gestartet.

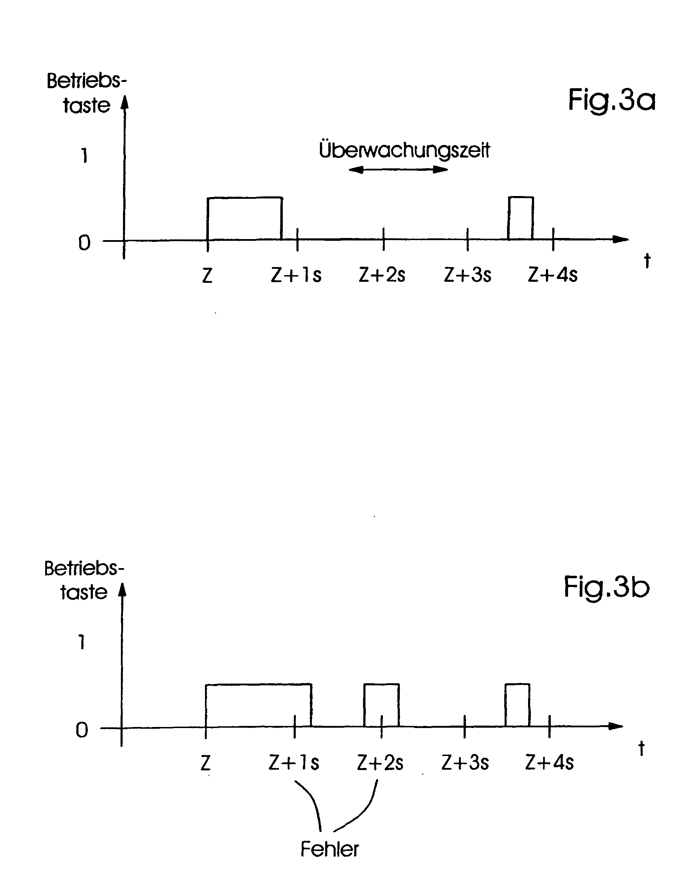

Beispiele für eine korrekte und eine fehlerhafte Einschaltsequenz sind in Fig. 3a bzw. 3b gezeigt, wobei von einer "Einzeit" von einer Sekunde und einer "Auszeit" von zwei Sekunden ausgegangen wird. Mit dem ersten Betätigen der Betriebstaste, deren Schaltzustand auf der Ordinate mit "0" bzw. "1" dargestellt ist, in einem Zeitpunkt t=z ertönt die Anfahrwarnung der Druckmaschine für drei Sekunden. Eine Sekunde nach dem Aktivieren der Betriebstaste auf dem Touch-Screen 2 muß die Betriebstaste losgelassen worden sein und darf in den nächsten zwei Sekunden kein Signal von der Betriebstaste erscheinen. Sollte innerhalb der Überwachungszeit von zwei Sekunden ein fehlerhaftes Signal erkannt worden sein, geht die Druckmaschinensteuerung 4 in den Grundzustand zurück. Fig. 3b zeigt beispielhaft zwei fehlerhafte Signalformen, eine in Form eines zu langen ersten Tastendrucks und eine in Form eines weiteren Tastendrucks während der "Auszeit". Nach Ablauf der Anfahrwarnung muß innerhalb von weiteren sechs Sekunden (dem in der Figur nur teilweise sichtbaren Zeitintervall zwischen z+3s und z+9s) die Betriebstaste ein zweites Mal betätigt worden sein, und erst dann wird die Druckmaschine tatsächlich gestartet. So ein Fall ist in Fig. 3a dargestellt.

### Bezugszeichenliste

- 1: Bedieneinheit
- 2: Touch-Screen
- 3: Verbindung
- 4: Druckmaschinensteuerung
- 5: Teilfeld

## Patentansprüche

1. Verfahren zum Einschalten einer Maschine mittels eines Sensors oder Sensorfeldes, der bzw. das während der Annäherung eines Körperteils eines Maschinenbedieners ein Einschaltsignal ausgibt, wobei die Maschine automatisch eingeschaltet wird, wenn das Einschaltsignal zweimal hintereinander erscheint und die folgenden Bedingungen erfüllt sind, die von einer Maschinensteuerung automatisch überprüft werden: das Einschaltsignal muss innerhalb einer vorgegebenen Zeit (S2) verschwunden sein, innerhalb eines ersten vorbestimmten Zeitintervalles, das dem Zeitpunkt des ersten Erscheinens des Einschaltsignals in einem vorbestimmten zeitlichen Abstand folgt, ist kein Einschaltsignal vorhanden (S3), und
innerhalb eines zweiten vorbestimmten Zeitintervalles, das dem ersten vorbestimmten Zeitintervall folgt, erscheint das Einschaltsignal von neuem (S4).

2. Verfahren nach Anspruch 1,
**dadurch gekennzeichnet, ,**
**dass** der Sensor oder das Sensorfeld berührungssensitiv ist und dass eine Annäherung eines Körperteils des Maschinenbedieners an den Sensor bzw. das Sensorfeld in einer Berührung desselben besteht.

3. Verfahren nach Anspruch 1 oder 2,
**dadurch gekennzeichnet,**
**dass** der vorbestimmte zeitliche Abstand zwischen dem Zeitpunkt des ersten Erscheinens des Einschaltsignals und dem ersten vorbestimmten Zeitintervall 1 Sekunde beträgt und dass das erste vorbestimmte Zeitintervall 2 Sekunden beträgt.

4. Verfahren nach einem der vorhergehenden Ansprüche,
**dadurch gekennzeichnet,**
**dass** das zweite vorbestimmte Zeitintervall dem ersten vorbestimmten Zeitintervall unmittelbar folgt und zwischen 3 und 6 Sekunden beträgt.

5. Verfahren nach einem der vorhergehenden Ansprüche,
**dadurch gekennzeichnet,**
**dass** die Maschine mittels eines berührungssensitiven Bildschirms (2) eingeschaltet wird, der ein Bild oder ein Teilbild (5) anzeigt, welches das Sensorfeld zum Einschalten der Maschine bildet.

6. Verfahren nach Anspruch 5,
**dadurch gekennzeichnet,**
**dass** der berührungssensitive Bildschirm zu einem Datenendgerät oder einem Personalcomputer gehört, das bzw. der über ein Datenkabel mit der Maschinensteuerung verbunden ist.

7. Verfahren nach einem der vorhergehenden Ansprüche,
**dadurch gekennzeichnet,**
**dass** die Maschine eine Druckmaschine ist.

## Claims

1. A method for starting a machine using a sensor or sensor field emitting a start signal upon an approach of a body part of a machine operator, whereby the machine is automatically started if the start signal appears twice consecutively and if the following conditions which are automatically verified by a machine controller, are fulfilled:
the start signal must have disappeared within a predefined time period (S2), a start signal is not present within a first predefined time interval following the time period of the first appearance of the start signal at a predefined time interval (S3), and
the start signal appears once again within a second predefined time interval following the first predefined time interval (S4).

2. The method according to claim 1,
**characterized in**
**that** the sensor or sensor field is touch-sensitive, and an approach of a body part of the machine operator to the sensor or sensor field involves contact with the sensor or sensor field.

3. The method according to claim 1 or 2,
**characterized in**
**that** the predefined time interval between the time period of the first appearance of the start signal and the first predefined time interval is 1 second and that the first predefined time interval is 2 seconds.

4. The method according to one of the preceding claims,
**characterized in**
**that** the second predefined time interval immediately follows the first predefined time interval and is between 3 and 6 seconds long.

5. The method according to one of the preceding claims,
**characterized in**
**that** the machine is started by means of a touch-sensitive screen (2) displaying an image or a partial image (5) which forms the sensor field for starting the machine.

6. The method according to claim 5,
**characterized in**
**that** the touch-sensitive screen is a component of a data terminal or a personal computer connected to the machine controller via a data cable.

7. The method according to one of the preceding claims,
**characterized in**
**that** the machine is a printing press.

## Revendications

1. Procédé pour la mise en marche d'une machine au moyen d'un détecteur ou champ de détection, qui au cours du rapprochement d'une partie du corps d'un utilisateur de la machine, délivre un signal de mise en marche, la machine étant mise en marche automatiquement lorsque le signal de mise en marche apparaît deux fois de suite et que les conditions suivantes, qui sont vérifiées automatiquement par une commande de machine, sont remplies :
le signal de mise en marche doit avoir disparu au cours d'un temps prescrit (S2),
au cours d'un premier intervalle de temps prédéterminé qui suit, après une période prédéterminée, l'instant de la première apparition du signal de mise en marche, il n'existe pas de signal de mise en marche (S3), et
au cours d'un second intervalle de temps prédéterminé, qui suit le premier intervalle de temps prédéterminé, le signal de mise en marche apparaît à nouveau (S4).

2. Procédé selon la revendication 1, **caractérisé en ce que** le détecteur ou le champ de détection est du type tactile, et **en ce que** le rapprochement d'une partie du corps de l'utilisateur de la machine du détecteur ou du champ de détection, consiste à toucher celui-ci.

3. Procédé selon la revendication 1 ou 2, **caractérisé en ce que** la période prédéterminée entre l'instant de la première apparition du signal de mise en marche et le premier intervalle de temps prédéterminé vaut 1 seconde, et **en ce que** le premier intervalle de temps prédéterminé vaut 2 secondes.

4. Procédé selon l'une des revendications précédentes, **caractérisé en ce que** le second intervalle de temps prédéterminé suit directement le premier intervalle de temps prédéterminé, et vaut entre 3 et 6 secondes.

5. Procédé selon l'une des revendications précédentes, **caractérisé en ce que** la machine est mise en marche au moyen d'un écran tactile (2), qui affiche une image ou une image partielle (5) formant le champ de détection pour la mise en marche de la machine.

6. Procédé selon la revendication 5, **caractérisé en ce que** l'écran tactile fait partie d'un terminal de données ou d'un ordinateur personnel, qui est relié à la commande de machine par l'intermédiaire d'un câble de transmission de données.

7. Procédé selon l'une des revendications précédentes, **caractérisé en ce que** la machine est une machine à imprimer.
